# EUROPEAN PATENT APPLICATION

(11) **EP 4 366 472 A1**
(43) Date of publication of application: **08.05.2024**
(21) Application number: 22205092.4
(22) Date of filing: 02.11.2022
(51) Int. Cl.: H05K 1/02, H05K 1/11, H05K 3/00

(54) **TESTING ELECTRICALLY CONDUCTIVE INTERCONNECTIONS**

(71) Applicant: AT & S Austria Technologie & Systemtechnik Aktiengesellschaft, 8700 Leoben-Hinterberg (AT)
(72) Inventor: Stubenberger, Gerhard, 8793 Trofaiach (AT); Galler, Christian, 8700 Leoben (AT); Bischof, Mario, 8763 Pölstal (AT); Stradner, Daniel, 8330 Feldbach (AT)
(74) Representative: Dilg, Haeusler, Schindelmann Patentanwaltsgesellschaft mbH

(57) **Abstract**

There is described a component carrier (100), comprising:
i) a stack (110) comprising at least two electrically conductive layer structures (130, 131) and at least one electrically insulating layer structure (102);
ii) an electrically conductive interconnection arrangement (152), comprising:
iia) at least two electrically conductive interconnections (120, 121) in the stack (110), electrically connecting said at least two electrically conductive layer structures (130, 131);
iib) at least one further electrically conductive interconnection (125)
that comprises similar physical properties and/or similar chemical properties and/or a similar geometry as the at least two electrically conductive interconnections; and
iii) a test region (150), comprising at least two connection areas (140) exposed at a common main surface (111) of the stack (110).

The at least two electrically conductive interconnections (120, 121) and the further electrically conductive interconnection (125) are electrically connected at respective extremities to corresponding connection areas (140) of the at least two connection areas (140) in the test region (150).

## Description

### Field of the Invention

The invention relates to a component carrier with electrically conductive interconnections. Further, the invention relates to an apparatus for determining the quality of an electrically conductive interconnection in the component carrier. Additionally, the invention relates to a method to determine the quality of the electrically conductive interconnection of the component carrier.

Thus, the invention may relate to the technical field of component carriers such as printed circuit boards and IC substrates, in particular in the context of testing the reliability of electrically conductive interconnections.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically and magnetically reliable so as to be operable even under harsh conditions.

In particular, testing the reliability of electrically conductive interconnections such as vias (vertical interconnection access) in a component carrier (preform), and thereby securing product quality and performance, remains a challenge.

Conventionally, electrically conductive connections are electrically contacted, e.g. through a wire, by a respective measurement device. An established method may be the so-called four-wire-test (FWR) that can be used to accurately measure the electrical resistance of interconnections in a non-destructive manner. Hereby, the measurement device comprises four wire, wherein two wires are dedicated for measuring a current, while the other two wires are dedicated for determining a voltage. From the result, the resistance of the electrical connection under test may be obtained. The measured resistance may be used as an electric parameter to evaluate the quality of the electrically conductive connection. For example, a via is not completely filled with copper and the cavity is filled with gas in the volume of the via or there is a loose interconnection such as a crack from via to metal trace.

FWT is conventionally used as an advanced electrical test at outgoing inspection for component carriers. One may determine the resistance for electrical nets, providing an improvement over a standard open/short test, like daisy chains, for which an open/short test is common. Even though daisy chain coupons may detect completely defect electrically conductive interconnections, the method may not be able to reliably detect weak interconnections.

In a conventional example, the daisy chain method is able to measure the electric resistance of all electrically conductive structures (including connection pads and traces), which are interconnected. So, electrically conductive interconnections and structures cannot be measured if they are in different regions of a component carrier and are not connected to the connection pads where the wire(s) of the FWT may be applied.

Since the connection pads comprise a relatively high metal amount, compared to e.g. (µ)-vias, and the electric resistance is proportional to the metal amount of each structure, a very high amount of the total resistance (which is measured by daisy chain measurements) belongs actually to the connection pads.

Therefore, the deviation of one weak via connection in correlation to the total amount of metal containing conductive structures may be difficult to measure in the state of the art. Thus, it may be desirable to reliably measure individual electrically conductive interconnections in an accurate manner with respect to only weak defects as well.

### Summary of the Invention

There may be a need to test at least one electrically conductive interconnection (in particular selectively) in a component carrier (preform) in an efficient, accurate, and reliable manner.

A component carrier, an apparatus, and a method are provided.

According to a first aspect of the invention, there is described a component carrier (preform), comprising:
i) a stack comprising at least two electrically conductive layer structures (in particular one above the other in the vertical direction of the stack) and at least one electrically insulating layer structure (in particular sandwiched between the at least two electrically conductive layer structures);
ii) a plurality of electrically conductive interconnections (in particular blind vias) in the stack electrically connecting said at least two electrically conductive layer structures; and
iii) a test region (e.g. a test area), provided in a portion of the component carrier, the test region comprising at least one further electrically conductive interconnection having similar and/or identical (in particular the same) physical (mechanical, electric) properties and/or chemical features and/or the same position in the depth of at least one of said electrically conductive interconnections,
wherein the two extremities (upper/lower) of said at least one further electrically conductive interconnection are connected to respective connecting areas (electrically conductive, in particular quadrangular-shaped, exposed at a common main surface (in particular in parallel with the direction of main extension of the component carrier) of the stack (and/or the component carrier)) exposed on same side of the component carrier (so that the electric conductivity of the interconnections in the stack may be tested through the connecting area exposed on the surface of the stack).

According to a second aspect of the invention, there is described an apparatus for determining the quality of an electrically conductive interconnection in a component carrier, said carrier comprising at least one test region having at least two exposed areas on its same side, said two exposed areas being each connected to one of the two extremities of a further electrically conductive interconnection having the similar and/or identical (in particular the same) mechanical/chemical features and/or the same position in the depth of at least one of said electrically conductive interconnection provided in an active region, said apparatus comprising an current measurement device, in particular an amperemeter, having a first and a second wires, and a voltage measurement device, in particular an voltmeter, having a third and a fourth wires, wherein said apparatus is configured to move said first, second, third and fourth wires so that during the electrically conductive interconnections test, one of the first or second wires and one of the third or the fourth wires are brought to be connected to the exposed area connected to the same extremity of the further electrically conductive interconnection, and the other of the first or second wires, and the other of the third or the fourth wires are each are brought to be connected to the different exposed area connected to the opposed extremity of the same further electrically conductive interconnection.

According to a third aspect of the invention, there is described a method to check the quality of an electrically conductive interconnection of a component carrier, said component carrier comprising:
- a plurality of the electrically conductive interconnections electrically connecting at least two electrically conductive structures, and
- at least a test region provided in a portion of the component carrier, said test region comprising at least one further electrically conductive interconnection having the similar and/or identical (in particular the same) mechanical/chemical features and/or the same position in the depth of the carrier of at least one of said electrically conductive interconnections,

wherein the two extremities of said at least one further electrically conductive interconnection are connected to respective connecting areas exposed on same side of the component carrier,
said method comprising the step of estimating the quality of the further electrically interconnection in function of at least one electrical value acquired from the two exposed areas.

The term "electrically conductive interconnection" may in this context denote an electrically conductive structure that is suitable to connect at least two electrically conductive (layer) structures (in a component carrier layer stack). In a preferred example, an electrically conductive interconnection may be a vertical electrically conductive interconnection such as a blind via in a component carrier layer stack. These electrically conductive interconnections may be provided on an active area of the component carrier where the electrically conductive structures and/or one or more components may be connected or connectable one to each other through said electrically conductive interconnection.

A plurality of electrically conductive interconnections may be arranged in a layer stack.

The term "further electrically conductive interconnection" may in this context denote an electrically conductive interconnection provided on a different area of the component carrier, comprising comparable properties as the electrically conductive interconnections. In an example, the further electrically conductive interconnection may be arranged at a comparable/similar vertical (along z) position in the stack. In a further example, the electrically conductive interconnection comprises comparable/similar mechanical/electrical/chemical properties as the electrically conductive interconnection(s) and/or a comparable/similar geometry. In a preferred embodiment, all mentioned parameters may be comparable/similar.

The further electrically conductive interconnection may be suitable to be electrically tested with respect to an electric parameter (e.g. voltage, current, resistance), in particular by one or more wire(s) of a measurement apparatus.

A plurality of electrically conductive interconnections may be arranged in a layer stack. In an example, at least two electrically conductive interconnections may be arranged side by side (at least partially) on the same vertical level in the stack. Hereby, the electrically conductive interconnections may be electrically connected with each other, for example by an electrically conductive layer structure of the stack. In an example, the lower extremities of at least two electrically conductive interconnections are electrically connected by a continuous electrically conductive layer structure of the stack, while the upper extremities may be connected by a non-continuous electrically conductive layer structure.

The term "test region" may in this context denote a region of the stack (or component carrier, depending on the design), wherein a measurement device, in particular a four-wire-test measurement device, may electrically contact the component carrier to perform the electrically conductive interconnection test.

To provide a reliable test of this further electrically conductive interconnection without affecting the functionality or the mechanical integrity of said electrically conductive interconnections and/or said electrically conductive structures and/or said one or more components, at least one further electrically conductive interconnection may be provided on a test area (e.g. inside or outside the active area), having the similar and/or identical (in particular the same) mechanical/chemical features and/or the same position in the depth of the stack as the at least one of said electrically conductive interconnections, allowing the test of the further electrically conductive interconnection in the test region, i.e. without involving the interconnection in the active area, and then preferably estimating the quality of the electrically conductive interconnections through this test.

The term "connection area" may in this context denote an electrically conductive area (e.g. a pad, a terminal, etc.) that is further electrically connected to the further electrically conductive interconnection to be tested. Hence, via the connection area, the further electrically conductive interconnection may be electrically contacted, even though the electrically conductive interconnection may be (fully) embedded in the stack. In an example, the connection area may be formed by a (discontinuous) electrically conductive layer structure arranged at the upper extremity of the respective electrically conductive interconnection(s). In another example (especially when the electrically conductive interconnection (arrangement) is buried in the stack), the connection area may be electrically connected to the further electrically conductive interconnection (arrangement) by additional interconnections such as vias. In a specific example, the connection area has a square shape, aimed for example to use as much available component carrier surface as possible; more specifically the square testing area of a connection area may be 1^{∗}1 mm (or smaller). In the present invention it is anyway not excluded the provisions of other shapes, such as circular, rectangular, or irregular shape. According to an alternative or additional embodiment of the present invention, the shape of the connection areas may be of different shape and/or of different dimensions and/or of different materials/color/roughness i.e. to clearly distinguish this connection area provided for the test reasons from other areas provided on the same side of the component carrier provided for other functions.

In an embodiment, the stack/component carrier surface may comprise a plurality of exposed connection areas, preferably arranged as an array. Thereby, a high number of further electrically conductive interconnections (arrangements) may be tested (individually) from the same component carrier side, even though at least some of them may be buried in the stack.

In the context of the present document, the term "same side of the component carrier" may particularly denote the same side, i.e. along the thickness direction, for that one of the two opposed main surfaces of the component carrier can be at least partially perpendicularly touched.

In a preferred embodiment the component carrier comprises a main body, i.e. a main stack only; in this preferred embodiment for "same side" it is meant the same main surface of the body/stack.

In an alternative embodiment, the component carrier comprises at least two bodies, i.e. a (stacked) PCB and a (stacked) substrate assembled on said PCB; in this embodiment, the term "same side of the component carrier" may mean the same side where the two main surfaces of the two bodies are at least partially reachable; on that purpose, the connecting areas can be provided both on one body, or the other body or in both bodies (in that case the further electrically conductive interconnection may be provided between the first and the second bodies).

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

The term "component carrier preform" may in particular refer to a component carrier under production, i.e. a semi-finished product. An example may be a panel that comprises a plurality of component carriers under manufacture, whereby the component carrier will be separated (singularization) after the manufacture process. Besides the component carriers under manufacture, the component carrier preform (panel) may further comprise separation areas in between the component carriers under manufacture, which separation areas will not form part of the final component carrier products anymore.

In the context of the present document, the term "component carrier" may encompass a discrete component carrier, a discrete component carrier preform, and a component carrier preform that comprises two or more component carriers under manufacture.

While in one example the connection areas may be arranged on component carriers under manufacture, in another example the connection areas may be arranged at the separation areas of a component carrier preform (panel). In the later example, the connection areas may thus not form part of the final component carrier product.

In an embodiment, the component carrier comprises a (layer) stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

According to an exemplary embodiment, the invention may be based on the idea that the quality of the electrically conductive interconnections in a component carrier (preform) can be estimated in an efficient, accurate, and reliable manner, when a specific architecture is provided, through the test of a further electrically conductive interconnection provided in a dedicated test region, without affecting the functionality or the mechanical integrity of said electrically conductive interconnections and/or said electrically conductive structures and/or said one or more components.

In particular, the connection areas may enable an easy and straightforward electrical contact with the (four) wires of a (four-wire-test) measurement device. Accordingly, the resistance of the further electrically conductive interconnection may be reliably determined, even though the electrically conductive interconnections may be buried in the layer stack. While conventional daisy chain approaches (see above) provide a result with regard to all interconnections, the described approach may provide individual results for the electrically conductive interconnections, so that defects may be detected more accurately and selectively. Further, in comparison to the conventional method, the described approach may provide more precise results that do not only detect completely defect interconnections (e.g. a completely break of the metal structure), but also weak interconnections, e.g. with partial breaks in the metal structure of the interconnection.

Furthermore, a statistical distribution of the measured electric parameter (in particular resistance) may be obtained to thereby provide a precise statement about the interconnection (processes) quality (e.g. a resistance map) of the component carrier.

### Exemplary Embodiments

According to an embodiment, the test region, in particular the exposed connection areas, is/are configured to be tested by a four wire test, FWT, functionality. This may provide the advantage that the resistance of (individual) electrically conductive interconnections can be determined in a reliable and efficient manner using established measurement devices.

The four-wire-test may be performed using a current measurement device and a voltage measurement device, thereby determining the resistance indirectly based on the current and the voltage. The name FWT is explained by two wires used by the current measurement device to contact a first connection area, and two further wires used by the voltage measurement device to contact a second connection area. In particular, each device contacts two different areas corresponding to two extremities of the connecting element (via) to test, otherwise, if two wires are connected to a single connection area, a short junction may be formed.

In an example, there are four exposed connection areas at the test region, each dedicated to be physically contacted by one of the four wires respectively. Using the architecture of the component carrier as described above, each wire may electrically contact (through the connection area) a respective extremity of an electrically conductive interconnection to be tested.

According to a further embodiment, the plurality of electrically conductive interconnections, and/or the further electrically conductive interconnection, are configured as at least one of a blind via, a through via, a plated through hole, an interconnection between component carrier stacks (sub-stacks of one component carrier), a wire, a nanowire, a sputtered material, a solder material, an electrically conductive adhesive. This may provide the advantage that a large variety of different electrically conductive interconnections can be tested with one and the same (resistance) testing method.

In an example, the component carrier layer stack is build-up by a plurality of layers, e.g. by lamination (insulating layer structures) and plating (electrically conductive layer structures). In another example, the stack is formed by a plurality of sub-stacks that are interconnected, for example by the electrically conductive adhesive.

According to a further embodiment, the plurality of electrically conductive interconnections are provided in an active area/region in a further portion of said component carrier, in particular in a plurality of active regions. This may provide the advantage that the electrically conductive interconnections, the quality of which would be estimated through the test of the further electrically conductive interconnection, are provided to a delimited area of the component carrier where all layers, components and functional features of the final product are provided (active region).

According to a further embodiment, the test region is provided between two active regions or between the external profile of the component carrier and the active region. This may provide the advantage of avoiding the interaction of the test region with the active region and/or to provide the further electrically conductive interconnection as close as possible to the electrically conductive interconnections for those the quality is estimated through the test of the specific the further electrically conductive interconnection.

According to a further embodiment, the component carrier further comprises a plurality of further electrically conductive interconnections.

According to a further embodiment, the further electrically conductive interconnections are provided in different positions with respect to the stacking direction (z) of the stack, in particular stacked one above the other.

This may provide the advantage that a plurality of electrically conductive interconnections can be (individually) tested, in particular independent if they are buried deep in the stack or (partially) surface-exposed. For example, in the case of many layers or even several sub-stacks, it may be challenging to reliably test all (interesting) electrically conductive interconnections. Nevertheless, the described approach may enable such a test within different layers, thereby enabling the preparation of a (three-dimensional) resistance map of the component carrier.

According to a further embodiment, the exposed connecting areas are (at least partially) covered (protected) by a surface finish, for example Ni-Au. Thereby, the connection areas may be efficiently protected, e.g. against oxidation. Furthermore, the exposed connection areas may comprise similar and/or identical physical property (electrical potential, roughness, heat conducting coefficient) and may be used for better recognition of the testing area.

According to a further embodiment, the connection between at least one of the two extremities of said at least one further electrically conductive interconnection to the respective exposed connecting areas comprises at least one (via) interconnection. In other words, the electrical connection between a further electrically conductive interconnection and the corresponding exposed connection areas comprises at least one (via) interconnection. This may provide the advantage that, even though further electrically conductive interconnections are buried (deep) in the stack vertical direction, they can still be reliably tested, because the electrically conductive interconnections are electrically connected to the corresponding exposed connection areas by respective interconnections, e.g. through vias.

According to a further embodiment, the test region covers at least partially the at least one electrically insulating layer structure. Said electrically insulating layer structure may (at least partially) embed the electrically conductive interconnection (arrangement) and the exposed connection areas may be formed on top. Furthermore, said electrically insulating layer structure may comprise a surface finish, in particular solder resist material.

According to a further embodiment, the component carrier is configured as a panel of printed circuit board preforms or IC substrate preforms.

According to a further embodiment, the component carrier comprises a hundred, in particular a thousand, or more electrically conductive interconnections.

According to a further embodiment the (further) electrically conductive interconnection is configured as a micro-via with a diameter of 100 µm or less, in particular 75 µm or less.

In an example, a common laser diameter may be 60 to 140 µm/160 µm, or 0.15 mm to 1.1 mm. Further, a conductive paste may have a diameter in the range from 90 µm to 300 µm.

According to a further embodiment the at least one of the two extremities of the at least one further electrically conductive interconnection is connected to two respective connecting areas, in particular each of the two extremities of said at least one further electrically conductive interconnection is connected to two respective connecting areas. This may provide the advantage that a higher amount of the component carrier can be used and/or different test areas are provided for the same further electrically conductive interconnection extremity, advantageous for some specific test equipment, i.e. FWT, where two different kind of values (current, voltage) must be measured.

According to a further embodiment the exposed connecting areas are repeatedly provided in the test region, thereby forming an array, in particular along linear directions. This may provide the advantage of the optimization of the area used for the test region.

According to a further embodiment, at least one extremity of the further electrically conductive interconnection is connected to at least two exposed connection areas, and the apparatus is configured to move the first wire, the second wire, the third wire, and the fourth wire, so that the first wire or the second wire is brought to be connected to one of said two exposed connection areas, and the third wire or the fourth wire is brought to be connected to the other one of said two exposed connection areas.

In this configuration, there may be a first connection area for the current measurement device and second connection area for the voltage measurement device, thereby increasing the selectivity and accuracy (or vice versa). In a further example, there may be four connections areas, one for each wire of the apparatus.

According to a further embodiment, during the electrically conductive interconnection test, each of said first, second, third and fourth wires are connected to a respective exposed area connecting each of the current measurement device (amperemeter/ammeter device) and the voltage measurement device (voltmeter device) to both extremities (upper and lower) of the further electrically conductive interconnection.

According to a further embodiment, both extremities of the further electrically conductive interconnection are each connected to at least two exposed connection area, and the apparatus is configured to move the first wire, the second wire, the third wire, and the fourth wire, so that each of said first, second, third and fourth wires are connected to a respective exposed area connecting each of the current measurement device and the voltage measurement device to both extremities of the further electrically conductive interconnection.

This may provide the advantage of selective contacts of the four wires on a specific assigned area to impart the contact of both the current measurement device and the voltage measurement device with both extremities of the further electrically conductive interconnection.

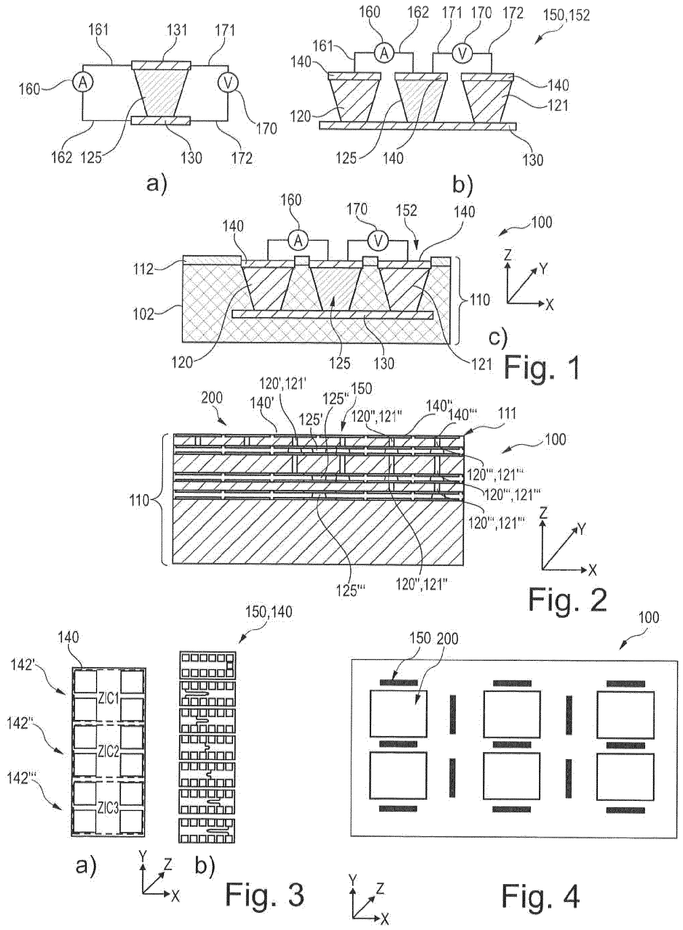

According to a further embodiment, the quality determination of each electrically conductive interconnection is estimated by the determined quality of the further electrically conductive interconnection, in particular of the further electrically conductive interconnection, at the spatially closest test region. This circumstance may directly result from the applied architecture, e.g. as shown in Figure 1c.

According to a further embodiment, the component carrier comprises a plurality of test regions on the common main surface, and the method further comprises: performing a component carrier quality determination/evaluation step by estimating the quality of the electrically conductive interconnections in active regions (electric contacts) of the component carrier based on the determined quality of the further electrically conductive interconnections of the plurality of test regions.

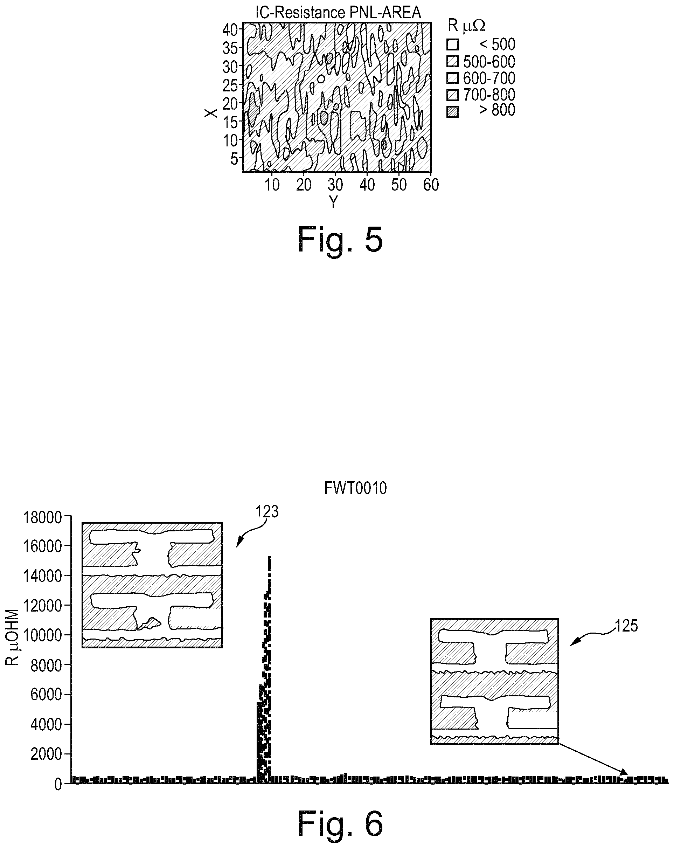

According to a further embodiment, the method further comprises: generating a correlation associated result (e.g. a resistance map as shown in Figure 5), wherein the correlation associated result comprises the association of a plurality of electrical parameters measured on the at least one further electrically conductive interconnection with the plurality of electrically conductive interconnections. In this manner, a (complete) evaluation of the component carrier (2D and/or 3D) with respect to the reliability of electrically conductive interconnections may be provided. In comparison to conventional methods, each electrically conductive interconnection may be evaluated individually and/or even weak defects may still be detected.

According to a further embodiment, the further electrically conductive interconnection comprises an inductor (e.g. a magnetic inductor and/or an electrically conductive structure comprising a coil like shape). This may provide the advantage that the inductive reactance may be efficiently determined. At least one of the electrically conductive interconnections may comprise an inductor as well.

According to a further embodiment, the further electrically conductive interconnection comprises a capacitor (e.g. a plate capacitor). This may provide the advantage that the capacitive reactance may be efficiently determined. At least one of the electrically conductive interconnections may comprise an capacitor as well.

According to a further embodiment, direct current (DC) is applied during resistance measurements. In a further embodiment, alternating current (AC) is applied for (inductive and/or capacitive) reactance measurements.

According to a further embodiment, the above described (resistance/reactance) measurements may be performed in the following ranges: current range: 10⁻¹⁸ to 10³ A (aA to kA range), voltage range: 10⁻⁸ to 10 V (10 nV to 10 V range).

According to a further embodiment, the measurement may be used to detect vias plated in a low quality (e.g. comprising (gas) inclusions from plating).

According to a further embodiment, the quality of a plated trace may be checked using the above described measurement. According to a further embodiment, the quality of a metal block (e.g. a heat sink) may be checked.

According to a further embodiment, the quality of the electrically vertical interconnection may be evaluated by the above described (four wire) measurements. This may provide the advantage that an efficient and reliable testing may be done in a non-destructive manner. Conventionally, such a measurement may be done in a cross section which is destructive (for the panel).

According to a further embodiment, a (selective) quality evaluation is provided in a non-destructive manner.

According to a further embodiment, the field failure rate may be reduced, since quality of the component carrier (preforms/panels) may be enhanced.

In an embodiment, the stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃). indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

According to a further aspect of the invention, there is described a component carrier (100), comprising:
i) a stack (110) comprising at least two electrically conductive layer structures (130, 131) and at least one electrically insulating layer structure (102);
ii) an electrically conductive interconnection arrangement (152), comprising: at least two electrically conductive interconnections (120, 121) in the stack (110), electrically connecting said at least two electrically conductive layer structures (130, 131);
iii) at least one further electrically conductive interconnection (125) that comprises similar physical properties and/or similar chemical properties and/or a similar geometry as the at least two electrically conductive interconnections (120, 121); and
iv) a test region (150), comprising at least two connection areas (140) exposed at a common main surface (111) of the stack (110).

Hereby, the at least two electrically conductive interconnections (120, 121) and the further electrically conductive interconnection (125) are electrically connected at respective extremities to corresponding connection areas (140) of the at least two connection areas (140) in the test region (150).

The term "electrically conductive interconnection arrangement" may in this context denote the above identified architecture with the at least two electrically conductive interconnections and the further electrically conductive interconnection, as described above. Said arrangement may be especially suitable to be tested for an electrical parameter using the four-wire-test method. In one example, the arrangement may be embedded in the stack but is at the same time at least partially exposed at the stack main surface. In another example, the arrangement may be fully embedded in the stack and is thus not exposed at the stack main surface (but only the corresponding connection areas).

According to a further embodiment, the test region comprises at least four exposed connection areas, and the at least four exposed connection areas are arranged in form of an array on the common surface of the component carrier.

According to a further aspect of the invention, there is described an apparatus (160, 170) for determining the quality of an electrically conductive interconnection (120, 121, 125) in a component carrier (100) as described above, the apparatus comprising:
i) a current measurement device (160), in particular an amperemeter, having a first wire (161) and a second wire (162); and
ii) a voltage measurement device (170), in particular a voltmeter, having a third wire (171) and a fourth wire (172).

According to a further embodiment, the apparatus is configured to connect for the quality determination through the respective exposed connection areas (140) :
the first wire (161) and the third wire (171) to a first extremity of the further electrically conductive interconnection (125); and
the second wire (162) and the fourth wire (172) to a second extremity, in particular opposed to the first extremity, of the further electrically conductive interconnection (125);
and/or
the first wire (161) to an extremity of a first electrically conductive interconnection (120) of the at least two electrically conductive interconnections (120, 121),
the second wire (162) to the first extremity of the further electrically conductive interconnection (125),
the third wire (171) to the first extremity to the further electrically conductive interconnection (125), and
the fourth wire (172) to an extremity of a second electrically conductive interconnection (121) of the at least two electrically conductive interconnections (120, 121).

According to a further aspect of the invention, there is described a method to determine the quality of an electrically conductive interconnection (120, 121, 125) of a component carrier (100), the method comprising:
determining the quality of the further electrically interconnection (125) in function of at least one electrical parameter, in particular at least one of resistance, inductive reactance, capacitive reactance, acquired from the respective connection area (140),
in particular wherein the electrical parameter is indirectly acquired through the measurement of the voltage and the current intensity from the exposed connection areas (140).

### Brief Description of the Drawings

The aspects defined above and further aspects of the invention are apparent from the examples of embodiment to be described hereinafter and are explained with reference to these examples of embodiment.
Figure 1a illustrates a further electrically conductive interconnection according to an exemplary embodiment of the invention.
Figure 1b illustrates a further electrically conductive interconnection in a test region according to an exemplary embodiment of the invention.
Figure 1c illustrates the test region of Figure 1b embedded in a stack according to an exemplary embodiment of the invention.
Figure 2 illustrates a cross-section of a test region according to an exemplary embodiment of the invention.
Figures 3a and 3b illustrate top views on the test region with connection areas according to exemplary embodiments of the invention.
Figure 4 illustrates a top view on the component carrier with active regions and tests regions according to an exemplary embodiment of the invention.
Figure 5 illustrates a resistance distribution map according to exemplary embodiments of the invention.
Figures 6 to 8 illustrate resistance distributions according to exemplary embodiments of the invention.
Figure 9 illustrates a current measurement device and a voltage measurement device according to an exemplary embodiment of the invention.

### Detailed Description of the Drawings

The illustrations in the drawings are schematic. In different drawings, similar or identical elements are provided with the same reference signs.

**Figure 1a** illustrates a further electrically conductive interconnection 125 according to an exemplary embodiment of the invention. The further electrically conductive interconnection 125 may be configured as a blind via, e.g. formed by laser-drilling which manufacture method results in the tapered shape. The upper part of the further electrically conductive interconnection 125 is termed here upper extremity, while the lower part of the further electrically conductive interconnection 125 is termed here lower extremity. The upper extremity is covered by an upper electrically conductive layer structure 131, while the lower extremity is arranged on a lower electrically conductive layer structure 130. In order to determine the resistance of the further electrically conductive layer structure 125, current and voltage are measured.

Schematically shown in this Figure are a first wire 161 and a second wire 162 of a current measurement device (e.g. an amperemeter) 160, respectively electrically connected to the upper electrically conductive layer structure 131 at the upper extremity and the lower electrically conductive layer structure 130 at the lower extremity. Further, there are shown a third wire 171 and a fourth wire 172 of a voltage measurement device (e.g. a voltmeter) 170, respectively electrically connected to the upper electrically conductive layer structure 131 at the upper extremity and the lower electrically conductive layer structure 130 at the lower extremity.

When the further electrically conductive interconnection 125 is at least partially embedded/buried in the component carrier, at least the direct connection of the measurement devices 160, 170 with the lower extremity is not actually possible.

In this regard, **Figure 1b** schematically illustrates a preferred embodiment to provide the contact of both extremities of the further electrically conductive interconnection 125 through exposed connecting areas 140 provided on the same side of the component carrier 100.

The further electrically conductive interconnection 125 preferably comprises the same mechanical/chemical features and/or the same position in the depth of at least one of said electrically conductive interconnections, preferably provided on an active region 200 (see Figure 4) of the component carrier as described below.

Preferably, two exposed areas 140 (compare Figure 4) are connected to the bottom extremity of the further electrically conductive interconnection 125 through the via interconnections 120, 121, more preferably each connected to this extremity through the lower conductive layer structure 130.

**Figure 1c****:** As a result, even if the further electrically conductive interconnection 125 is embedded in the component carrier (in the example of Figure 1c the further electrically conductive interconnection 125 is embedded in the electrically insulating layer structure 102), using a current measurement device 160 and a voltage measurement device 170 through both further electrically conductive interconnection extremities is possible through the contact of the measurement devices with the exposed connecting areas 140. In the shown preferred embodiment, the current measurement device 160 is electrically connected between exposed connecting areas 140 provided on the upper extremity of the first via interconnection 120 (with the first wire 161) and through the exposed connecting areas 140 provided on the upper extremity of the further electrically conductive interconnection 125 (with the second wire 162). Further, the voltage measurement device 170 is electrically connected between the upper extremity of the second via interconnection 121 (with the fourth wire 172) and through the exposed connecting areas 140 provided on the upper extremity of the further electrically conductive interconnection 125 (with the third wire 171).

In this configuration, a first electric circuit can be closed between the first via interconnection 120, the further electrically conductive interconnection 125, and the current measurement device 160, and a second electric circuit can be closed between the second via interconnection 121, the further electrically conductive interconnection 125, and the current measurement device 170.

In other words, by coupling a via interconnection 120, 121 in an electric connection between the upper extremity and the lower extremity of the further electrically conductive interconnection 125, an electrical parameter, preferably the resistance, of the further electrically conductive interconnection 125 can be determined individually and reliably.

**Figure 2** illustrates a side view of a cross-section through a test region 150 according to an exemplary embodiment of the invention. This test region 150 comprises a stack 110 that is formed by a plurality of sub-stacks, in particular with several electrically conductive structures that are interconnected by a plurality, three as illustrated, further electrically conductive interconnections ZIC1 125', ZIC2 125" and ZIC3 125‴ in the vertical direction (Z-interconnection, ZIC).

All this further electrically conductive interconnections ZIC1 125', ZIC2 125" and ZIC3 125'" have the same mechanical/chemical features and preferably the same position in the depth of a respective electrically conductive interconnections provided for example in an active area 200 as below disclosed.

Differently from the embodiment shown in Figures 1b and 1c, several further electrically conductive interconnections 125 are provided, preferably all completely embedded/buried in the component carrier.

Preferably, the (electrical) connection of the two extremities of the further electrically conductive interconnections ZIC1 125' is possible through at least two exposed connecting areas 140' provided on one side of the component carrier, each one connected to a different extremity of the further electrically conductive interconnections ZIC1 125', preferably through the via interconnections 120' and 121'.

Preferably, the (electrical) connection of the two extremities of the further electrically conductive interconnections ZIC2 125" is possible through at least two exposed connecting areas 140" provided on one side of the component carrier, each one connected to a different extremity of the further electrically conductive interconnections ZIC1 125" through the via interconnections 120" and 121".

Preferably, the (electrical) connection of the two extremities of the further electrically conductive interconnections ZIC2 125'" is possible through at least two exposed connecting areas 140'" provided on one side of the component carrier, each one connected to a different extremity of the further electrically conductive interconnections ZIC1 125'" though the via interconnections 120'" and 121‴.

Each of the further electrically conductive interconnections ZIC1 125', ZIC2 125" and ZIC3 125‴ can be electrically tested by a test apparatus 160, 170, through the exposed connecting areas 140', 140‴, 140‴.

**Figures 3a and 3b** illustrate possible preferred embodiments shown in Fig. 2, where each extremity of each further electrically conductive interconnections ZIC1 125', ZIC2 125" and ZIC3 125'" are connected to two exposed connecting areas 140', 140", 140‴.

Preferably, each resulting four exposed areas form a first array 142', that can be preferably placed with respect to the other two exposed areas group forming a second array 142", more preferably being placed with other exposed areas groups (corresponding to additional respective further electrically conductive interconnections as shown in Figure 3b) forming a third array 142‴. There are in particular shown top views on the sub-stacks which are later-on buried during build-up of the stack 110.

Figure 3b: in the cross-section of Figure 2, the interconnection layers L2 to L7 are indicated. Figure 3b shows top views on the interconnection layers L2 to L7 with respective connection areas 140 arranged as an array 142.

**Figure 4** illustrates a top view on a component carrier preform 100 according to exemplary embodiments of the invention. The component carrier preform 100 is a semi-finished product configured as a rectangular panel that comprises six component carriers under production, which will be separated after the manufacture process.

In this example, the test regions 150 with the connection areas 140 in form of an array 142 are formed in the same component carrier preform 100, in a region, the test region in specific embodiment, that will be discarded during the separation process and will not form part of the final component carrier products. As can be seen in Figure 4, there are provided several, in particular thirteen test regions around the active areas 200, that in this specific embodiment represents the six component carriers. The further electrically conductive interconnection 125 comprised in each test region 150 are preferably realized in at least one of: the same process, with the same material, with the same dimensions, in the same position along the thickness of the component carrier 100 as the electrically conductive interconnections provided in each active area 200.

Consequently, the closer the test region 150 is to the active region, the more reliable is the quality estimation of the electrically conductive interconnections in the active area 200.

To perform a reliable statistical evaluation, the test regions 150 are preferably provided around each active area 200.

Preferably, the quality determination of each electrically conductive interconnection is estimated by the determined quality of the further electrically conductive interconnection 125, in particular of the further electrically conductive interconnection 125 at the spatially closest test region 150.

Preferably, the test region 125 is provided between two active areas 200 and/or between the external profile of the component carrier 100 and one active area 200.

Due to the proper placement of the testing regions, a detailed electrically conductive interconnections quality estimation can be reached as disclosed in Figure 5.

Moreover, **Figure 5** illustrates a resistance distribution map estimation according to an exemplary embodiment of the invention. Based on a plurality (e.g. in the range of hundreds) of resistance measurements of the further electrically conductive interconnections 125, in the several test regions, the simulation of the resistance distribution map of the component carrier 100 can be produced. In this manner, a reliable quality control can be established. In this example, weak interconnections (defects) are indicated by a different color.

**Figures 6 to 8** illustrate results regarding resistance distributions of further electrically conductive interconnections 125 according to exemplary embodiments of the invention.

Figure 6: the x-axis shows the plurality of individual resistance measurements of the further electrically conductive interconnections 125, while the y-axis shows the corresponding measured resistance. Most electrically conductive interconnections 125 (µ-vias) comprise essentially the same low resistance (see example with intact vias). Nevertheless, some weak or even broken electrically conductive interconnections 123 (see detailed view) show a clearly increased resistance value.

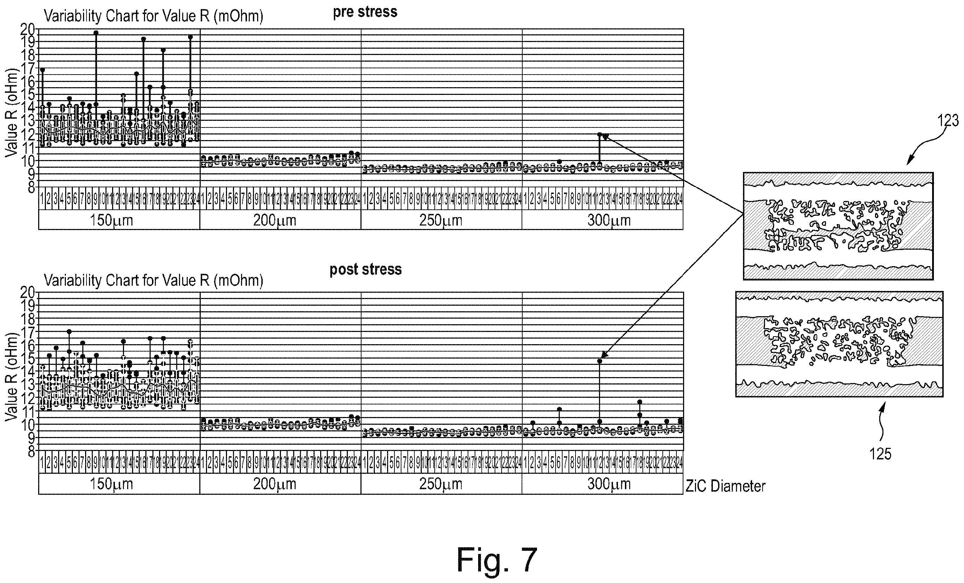

Figure 7: comparable to Figure 6, outliers with respect to the resistance value are represented by individual weak interconnections 123 (see detailed views).

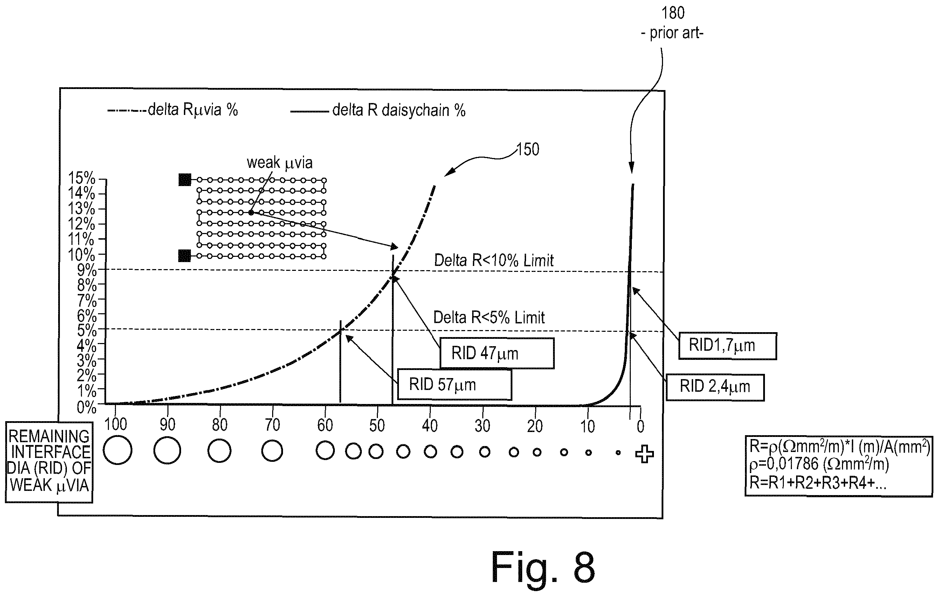

Figure 8 demonstrates that weak or broken interconnections 123 (here 104 µm diameter vias) can be identified much more reliably with the described approach in the test regions 150 in comparison to a conventional example 180. The x-axis indicates the remaining interface at a defect position in a via. The y-axis shows the remaining conductive area (cross sectional area) of an interconnection, in this case a laser via. While the conventional approach (daisy chain) 180 essentially only detects fully broken vias (with a remaining interface of 0), the described approach already detects, in this example, defects with a remaining interface diameter of 57 or 47 µm (i.e. weak interconnections).

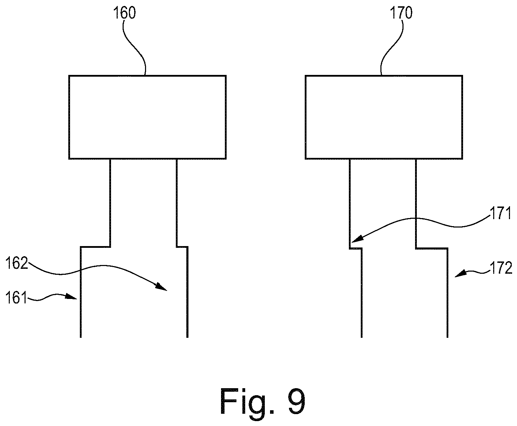

**Figure 9** illustrates a current measurement device 160 and a voltage measurement device 170 according to an exemplary embodiment of the invention. As already described above, the current measurement device 160 comprises a first wire 161 and a second wire 162 to electrically contact tat least one connection area 140. Accordingly, the voltage measurement device 170 comprises a third wire 171 and a fourth wire 172 to electrically contact at least one further connection area 140. The current measurement device 160 and the voltage measurement device 170 can be implemented in a common apparatus that is configured to perform a four-wire-test measurement.

### Reference signs

- 100: Component carrier
- 102: Electrically insulating layer structure
- 110: Stack
- 111: Main surface
- 112: Solder resist
- 120: First via interconnection
- 121: Second via interconnection
- 123: Weak/broken electrically conductive interconnection
- 125: Further electrically conductive interconnection
- 130: Lower electrically conductive layer structure
- 131: Upper electrically conductive layer structure
- 140: Connection area
- 142: Array
- 150: Test region
- 152: Electrically conductive interconnection arrangement
- 160: Current measurement device
- 161: First wire
- 162: Second wire
- 170: Voltage measurement device
- 171: Third wire
- 172: Fourth wire
- 180: Conventional test method
- 200: Active area/region

## Claims

1. A component carrier (100), comprising:
a stack (110) comprising at least two electrically conductive layer structures (130, 131) and at least one electrically insulating layer structure (102) ;
a plurality of electrically conductive interconnections in the stack (110) electrically connecting said at least two electrically conductive layer structures (130, 131); and
a test region (150) provided in a portion of the component carrier (100), the test region (150) comprising at least one further electrically conductive interconnection (125) having the same mechanical/chemical features and/or the same position in the depth of at least one of said electrically conductive interconnections,
wherein the two extremities of said at least one further electrically conductive interconnection (125) are connected to respective connecting areas (140) exposed on same side of the component carrier (100).

2. The component carrier (100) according to claim 1,
wherein the test region (150), in particular the exposed connection areas (140), is configured to be tested by a four wire test, FWT, functionality.

3. The component carrier (100) according to claim 1 or 2,
wherein the plurality of electrically conductive interconnections, and/or the further electrically conductive interconnection (125), are configured as at least one of a blind via, a through via, a plated through hole, an interconnection between component carriers, a wire, a nanowire, a sputtered material, a solder material, an electrically conductive adhesive.

4. The component carrier (100) according to any one of the preceding claims, wherein
the plurality of electrically conductive interconnections are provided in an active region (200) in a further portion of said component carrier (100), in particular in a plurality of active regions (200).

5. The component carrier (100) according to claim 4, wherein the test region (150) is provided between two active regions (200) or between the external profile of the component carrier (100) and the active region (200).

6. The component carrier (100) according to any one of the preceding claims, wherein a plurality of further electrically conductive interconnections (125) are provided.

7. The component carrier (100) according to claim 6,
wherein the further electrically conductive interconnections (125) are provided in different positions with respect to the stacking direction (z) of the stack (110), in particular stacked one above the other.

8. The component carrier (100) according to any one of the preceding claims, wherein the connection between at least one of the two extremities of said at least one further electrically conductive interconnection (125) to the respective exposed connecting area (140) comprises at least one via interconnection (120, 121).

9. The component carrier (100) according to any one of the preceding claims, wherein at least one of the two extremities of the at least one further electrically conductive interconnection (125) is connected to two respective connecting areas (140), in particular each of the two extremities of said at least one further electrically conductive interconnection (125) is connected to two respective connecting areas (140).

10. The component carrier (100) according to any one of the preceding claims, wherein the exposed connecting areas (140) are repeatedly provided in the test region (150), thereby forming an array (142), in particular along linear directions.

11. An apparatus (160, 170) for determining the quality of an electrically conductive interconnection in a component carrier (100), said component carrier (100) comprising at least one test region (150) having at least two exposed areas (140) on its same side, said two exposed areas (140) being each connected to one of the two extremities of a further electrically conductive interconnection (125) having the same mechanical/chemical features and/or the same position in the depth of at least one of said electrically conductive interconnection provided in an active region (200),
said apparatus (160, 170) comprising:
a current measurement device (160), in particular an amperemeter, having a first wire (161) and a second wire (162), and
a voltage measurement device (170), in particular an voltmeter, having a third wire (171) and a fourth wire (172),
wherein
said apparatus (160, 170) is configured to move said first, second, third and fourth wires (161, 162, 171, 172) so that during the electrically conductive interconnections test, one of the first or second wires and one of the third or the fourth wires are brought to be connected to the exposed area (140) connected to the same extremity of the further electrically conductive interconnection (125), and the other of the first or second wires, and the other of the third or the fourth wires are each are brought to be connected to the different exposed area (140) connected to the opposed extremity of the same further electrically conductive interconnection (125).

12. The apparatus (160, 170) according to claim 11,
wherein at least one extremity of the further electrically conductive interconnection (125) is connected to at least two exposed connection areas (140), and
wherein the apparatus (160, 170) is configured to move the first wire (161), the second wire (162), the third wire (171), and the fourth wire (172), so that the first wire (161) or the second wire (162) is brought to be connected to one of said two exposed connection areas (140), and the third wire (171) or the fourth wire (172) is brought to be connected to the other one of said two exposed connection areas (140).

13. The apparatus (160, 170) according to claim 12,
wherein both extremities of the further electrically conductive interconnection (125) are each connected to at least two exposed connection areas (140), and wherein the apparatus (160, 170) is configured to move the first wire (161), the second wire (162), the third wire (171), and the fourth wire (172), so that each of said first, second, third and fourth wires are connected to a respective exposed area connecting each of the current measurement device (160) and the voltage measurement device (170) to both extremities of the further electrically conductive interconnection (125).

14. A method to check the quality of an electrically conductive interconnection of a component carrier (100), said component carrier (100) comprising a plurality of the electrically conductive interconnections electrically connecting at least two electrically conductive structures (130, 131), and at least a test region (150) provided in a portion of the component carrier (100), said test region (150) comprising at least one further electrically conductive interconnection (125) having the same mechanical/chemical features and/or the same position in the depth of the component carrier (100) of at least one of said electrically conductive interconnections, wherein the two extremities of said at least one further electrically conductive interconnection (125) are connected to respective connecting areas (140) exposed on same side of the component carrier (100), said method comprising:
estimating the quality of the further electrically interconnection (125) in function of at least one electrical value acquired from the two exposed areas (140).

15. The method according to claim 14,
wherein the quality determination of each electrically conductive interconnection is estimated by the determined quality of the further electrically conductive interconnection (125), in particular of the further electrically conductive interconnection (125) at the spatially closest test region (150); and/or
wherein the component carrier (100) comprises a plurality of test regions (150) on the common main surface (111), and wherein the method further comprises:
performing a component carrier (100) quality evaluation step by estimating the quality of the electrically conductive interconnections in active regions (200) of the component carrier (100) based on the determined quality of the further electrically conductive interconnections (125) of the plurality of test regions (150); and/or
wherein the method further comprises:
generating a correlation associated result,
wherein said correlation associated result comprises the association of a plurality of electrical parameters measured on the at least one further electrically conductive interconnection (125) with the plurality of electrically conductive interconnections.
